# EUROPEAN PATENT APPLICATION

(11) **EP 1 035 563 A1**
(43) Date of publication of application: **13.09.2000**
(21) Application number: 99104660.8
(22) Date of filing: 09.03.1999
(51) Int. Cl.: H01L 21/00

(54) **A handling device and method for moving a pod**

(71) Applicant: MOTOROLA, INC., Schaumburg, IL 60196 (US); Siemens Aktiengesellschaft, 80506 München (DE); Semiconductor300 GmbH & Co KG, 01074 Dresden (DE)
(72) Inventor: Stanley, Timothy Daryl, 01109 Dresden (DE); Lering, Michael, 09188 Bubenreuth (DE)
(74) Representative: Richardt, Markus Albert

(57) **Abstract**

The invention allows to facilitate the handling of front opening unified pods, reduces the argonomic hazard for operators and increases the safety of wafer damage during transportation. This is accomplished by providing a handling device being attached to a support and which produces about half the lift of the weight of a fully loaded pod. This way an operator is relieved from about half the weight.

## Description

### Field of the Invention

The invention generally relates to the field of clean rooms for semiconductor fabrication, in particular to the transportation of pods within such a clean room.

### Background of the Invention

So called front opening unified pods (FOUP) are commonly used in the prior art for the transportation of wafers in a clean room. A clean room typically comprises a number of tools to perform a variety of semiconductor manufacturing processing steps. During the manufacturing process a wafer needs to be transported from and to such tools in a given sequence. This is done by placing a number of wafers into a FOUP. The FOUP is then carried by an operator to the tool, which is next in the processing sequence.

It is also known in the prior art to use partly automated person guided vehicles (PGV) to transport FOUPS from one place to another within a clean room. Also partly automated virtual stokkers are used to shelve FOUPS in a clean room.

It is therefore an object of the invention to provide for an improved handling of pods in a clean room.

### Summary of the invention

The underlying problem of the invention is solved by applying the features let down in the independent claims. Preferred embodiments are given in the dependent claims.

The invention is advantageous in that it relieves an operator from having to carry the full load of a pod being loaded with wafers. Thereby the ergonomic working conditions are improved. Operators can move a pod between a transport card and a load pod of a tool and between a transport card and storage shelves without having to carry the full load of the pod.

In addition to the ergonomic advantage the invention offers the further advantage of increased safety of transportation of the pods. The invention prevents that damage is caused to the wafers in case the pod is accidentally or unintentionally released by the operator. In particular, the handling device of the invention prevents a pod, which is being released by the operator, to drop to the ground in free fall.

The advantages of the invention are crucial for the handling of 300-mm wafers because of the size, weight and value of such wafers.

According to a preferred embodiment of the invention the handling device is controlled so that a resultant force at the lower end of the handling device is constant. A convenient value for the resultant force is about half the weight of the fully loaded port, which is about 4 kg in the case of 300-mm wafers.

### Brief Description of the Drawings

FIG. 1 is a schematic view of a clean room having a handling device of the invention to load a tool;
FIG. 2 is an alternative embodiment of the clean room of FIG. 1;
FIG. 3 is a schematic cross sectional view of the handling device of the invention.

### Detailed Description of the invention

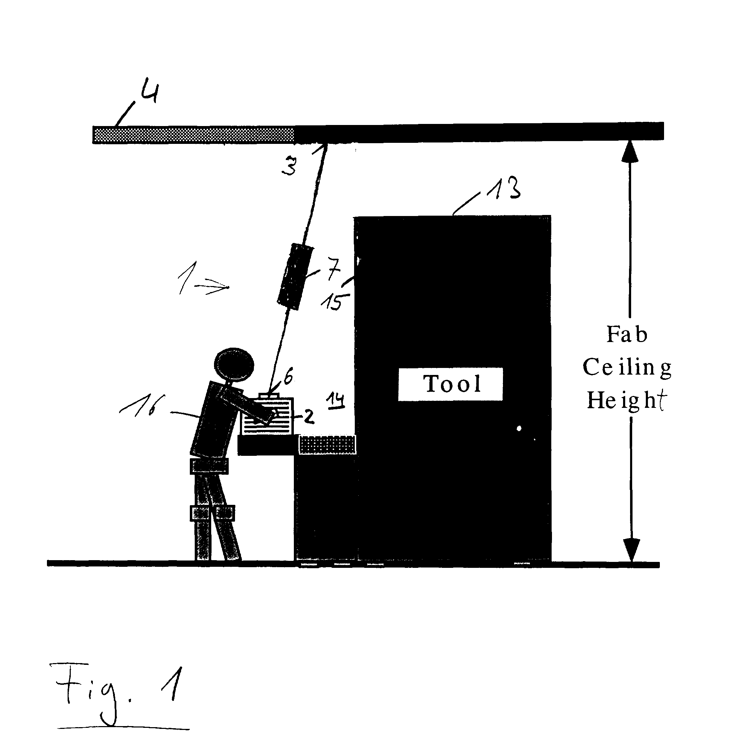

With reference to FIG. 1 a clean room 12 is described in greater detail in the following. The clean room 12 has a tool 13 to perform a semiconductor-processing step such as sputtering, chemical wafer deposition, iron implantation, a neeling or any other processing step. The tool 13 has a port 14 to receive a port 2. The port 2 is loaded with 300-mm wafers and weights about 8 kg.

Further the clean room has a handling device 1 to assist the handling of the pod 2 by an operator 16. The handling device 1 has an upper end 3, a lower end 6 and a lift providing means 7, which is arranged between the lower end 6 and the upper end 3. In the preferred embodiment considered here the lift providing means 7 is a cylindrical spring. Alternatively other elastic arrangements can be employed, such as stretchable rubber belts or the like. The upper end 3 of the handling device 1 is coupled to a support 4 of the clean room 12. In the example considered here the support 4 is the ceiling of the clean room 12. The lower end 6 of the handling device 1 is coupled to the pod 2. When the operator 16 lifts the pod 2 this has the advantage that the operator 16 does not have to carry the complete weight of the pod 2 but only the difference between the lift provided by the handling device 1 and the weight of the pod 2.

If the operator 16 wants to move the pod 2 from one place within the clean room 12 to another, for example from a shelve (not shown) to the tool 13, the following method is applied: the operator 16 couples the lower end of the handling device 1 to the pod 2. Then the operator gribs the pod 2 and carries the pod 2 to the port 14 of the tool 13. During this movement from the shelve to the port 14 the operator need only to provide about half the weight of the pod 2 since the other half of the required force is produced by the handling device 1. Such a movement is facilitated if a coupling between the lower end 6 and the pod 2 reefs a rotatory degree of freedom.

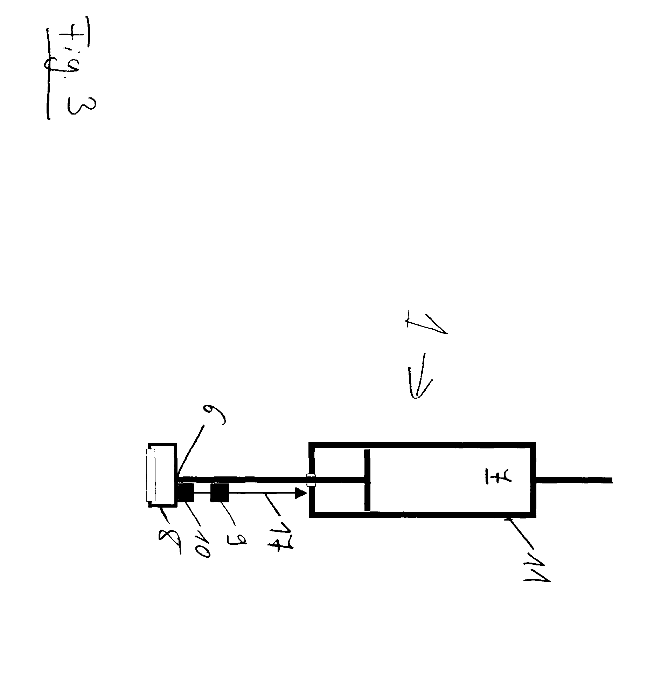

In the preferred embodiment considered here the tool 13 has a magnetic member 15 which is the font surface of the tool 13. The lift providing means 7 has also a magnetic member 11 as shown in FIG. 3. The magnetic fields as produced by the magnetic members 7 and 15 are such that the lift providing means 7 is attracted towards the tool 13. If the handling device 1 is not used the operator 16 can move the handling device 1 into a direction of the tool 13 so that the lift providing means 7 is attracted to and adheres to the magnetic member 15 of the tool 13. This has the further ergonomic advantage that the handling device 1 is not in the operator's way when not in use.

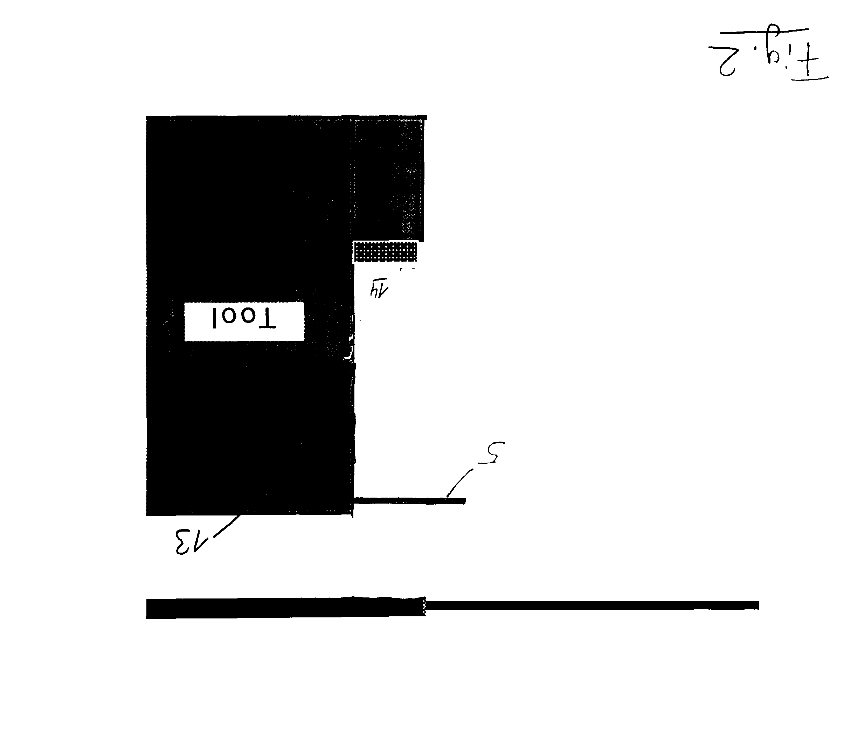

FIG. 2 shows a further preferred embodiment of the invention. In the embodiment of FIG. 2 a support beam 5 is mounted to the front of the tool 13. The support 5 serves to support the handling device as an alternative of coupling the handling device to the ceiling of the clean room as shown in FIG. 1.

FIG. 3 shows an alternative embodiment of the handling device 1. The handling device 1 of FIG. 3 has a controllable pneumatic or hydraulic lifter 7. The lifter 7 is controlled by a signal 17 applied to the lifter 7. The signal 17 is produced by a control unit 9, which is coupled to a sensor 10. The sensor 10 measures a resultant force, which is applied to a clip 8 of the handling device 1.

The clip 8 is attached to the lower end 6 of the handling device 1 and is formed to fit to a top flinch of the pod to provide for a detachable coupling.

In operation when a pod 2 (cf. FIG. 1 ) is coupled to the handling device 1 and gribbed by the operator a resultant force is applied to the clip 8. This resultant force is measured by the sensor 10. The sensor 10 can be realized as a piezzo electric element.

As the resultant force exercised on the clip 8 is supposed to be approximately constant this means that irrespective of the operating conditions the lift providing means 7 is to produce the same amount of lift. This is accomplished by sensing the resultant force by means of the sensor 10, which produces a signal, which is transmitted to the control unit 9. If the signal indicates that the resultant force is smaller than the predefined constant force - of approximately 4 kg in case of 300-mm wafers - the lift providing means 7 is controlled via the signal 17 to increase its lift. In the opposite case the lift providing means 7 is controlled to reduce its lift.

This results in the following operating situations:
a) The pod is shelved and the operator needs to drag the lower end 6 of the handling device 1 towards the pod in order to couple the clip 8 to the pod. In this case the operator needs to overcome the lift produced by the handling device 1 in order to stretch the handling device 1 towards the pod. This force to be provided by the operator for stretching the handling device 1 is about 4 kg - corresponding to the predefined lift to be produced by the lift providing means 7 under all circumstances.
b) When the handling device 1 is coupled to the pod the operator grabs the pod and provides a lifting force. In order to move the pod upwards the lift to be provided by the operator need only be slightly above 4 kg since the handling device 1 continues to provide lift of 4 kg also.
c) When the operator drops the pod the handling device continues to constantly provide 4 kg of lift so that the pod smoothly sinks to the ground.

According to a further preferred embodiment the control unit 9 controls the lift providing means 7 through signal 17 to provide dampening in case the force being sensed by the sensor 10 abruptly changes. This way the risk for damaging of wafers during transportation is further reduced.

## Claims

1. A handling device (1 ) for handling a pod (2), said handling device having an upper end (3) being adapted to be coupled to a support (4, 5) and a lower end (6), said lower end being adapted to be detachably coupled to said pod, said handling device further comprising lift providing means (7) for providing a lifting force to said pod via said lower end, said means for providing a lifting force being arranged between said upper end and said lower end.

2. The handling device according to claim 1, said handling device being adapted to provide a rotatory degree of freedom to said lower end when said upper end is coupled to said support.

3. The handling device according to anyone of the preceding claims, said lifting force being approximately half the weight of said pod.

4. The handling device according to anyone of the preceding claims, said lower end having a clip (8) for coupling of said lower end to said pod.

5. The handling device according to claim 4, said clip being adapted to be coupled to a top flange of said pod.

6. The handling device according to anyone of the preceding claims, said lift providing means being a spring, said spring having a first end and a second end, said first end being coupled to said upper end and said second end being coupled to said lower end.

7. The handling device according to anyone of the preceding claims, said lift providing means comprising control means (9) and sensor means (10) for sensing a resultant force being applied to said lower end, said sensor means being coupled to said control means, said control means being adapted to control the lifting force provided by said lift providing means.

8. The handling device according to claim 7 said control means being adapted to control the lifting force provided by said lift providing means so that said resultant force remains approximately constant.

9. The handling device according to claims 7 or 8, said control means being adapted to control the lifting force provided by said lift providing means so that a movement of said pod is dampened.

10. The handling device according to anyone of the claims 7 to 9, said lift providing means comprising a pneumatic lifter (7) for providing said lift, said pneumatic lifter being coupled to said control means.

11. The handling device according to anyone of the claims 7 to 9, said lift providing means comprising a hydraulic lifter (7) for providing said lift, said pneumatic lifter being coupled to said control means.

12. The handling device according to anyone of the preceding claims having a magnetic member (11).

13. A clean room (12) comprising a tool (13) having a port (14) for receiving a pod, a support and a handling device according to anyone of the preceding claims, said handling device being coupled to said support.

14. The clean room according to claim 13, said support being a beam (5) attached to a front of said tool above said port.

15. The clean room according to claims 13 or 14, said tool having means (15) for providing a magnetic field of opposite polarity to said magnetic member of said handling device according to claim 14.

16. A method for moving a pod by means of a handling device according to anyone of the preceding claims, said method comprising the steps of coupling said lower end of said handling device to said pod, applying an operator provided force to said pod for moving the pod to a desired location and decoupling said lower end from said pod.
